# EUROPEAN PATENT APPLICATION

(11) **EP 3 226 015 A1**
(43) Date of publication of application: **04.10.2017**
(21) Application number: 16168285.1
(22) Date of filing: 04.05.2016
(51) Int. Cl.: G01R 31/36

(54) **WIRELESS BATTERY MANAGEMENT SYSTEM AND METHOD OF OPERATING THE SAME**

(30) Priority: 30.03.2016 TW 105110003
(71) Applicant: DHC Specialty Corp., Taipei (TW)
(72) Inventor: Hsiao, Hung-Ching, Taipei (TW); Yang, Sun-Fan, Taipei (TW)
(74) Representative: Becker Kurig Straus

(57) **Abstract**

A wireless battery management system includes at least one battery tester (20) and a wireless terminal apparatus (10). The at least one battery tester (20) is electrically connected to at least one battery unit (30). The wireless terminal apparatus (10) includes a wireless communication unit (11), a display unit (12), and a user interface (13). The user interface (13) is displayed on the display unit (12) and operates an application program of the wireless terminal apparatus (10). The application program is executed by the wireless terminal apparatus (10) to provide a test and monitor function to control the battery tester (20) testing and monitoring the battery unit (30) correspondingly connected to the battery tester (20). Accordingly, readability of the battery test results and convenience of monitoring and sharing the battery test results are increased.

## Description

### 1. Technical Field

The present disclosure relates generally to a battery management system and a method of operating the same, and more particularly to a wireless battery management system and a method of operating the same.

### 2. Description of the Prior Arts

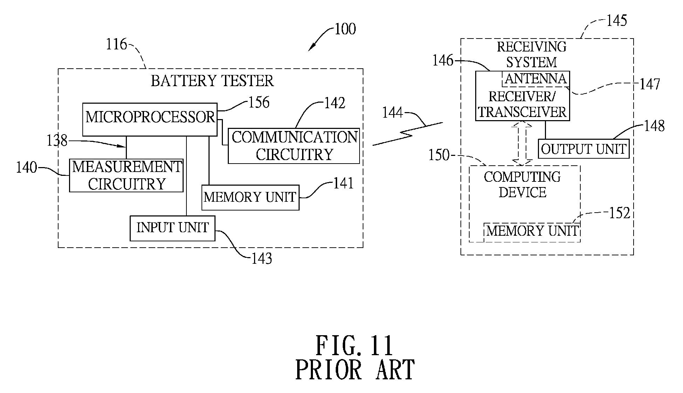

U.S. Patent 7,772,850 discloses a wireless battery tester with information encryption means. FIG.11 shows a block diagram of a conventional wireless battery testing system. The wireless battery testing system 100 includes a battery tester 116. The battery tester 116 includes a measurement circuitry 140, a memory unit 141 and an input unit 143 coupled to a microprocessor 156. The microprocessor 156 is also operably coupled to a communication circuitry 142. The measurement circuitry 140 and the microprocessor 156 together form a battery test circuitry 138. The microprocessor 156 generates a battery test result based on measurements made by the measurement circuitry 140 and the microprocessor 156 provides the battery test result to the communication circuitry 142. The communication circuitry 142 transmits battery test results over a wireless communication signal 144, such as a diffused infrared signal or a radio frequency (RF) signal to an external receiving system 145.

The external receiving system 145 includes a receiver/transceiver 146 having an antenna 147, an output unit 148 and a computing device 150 having a memory unit 152. The computing device 150 is connected to the receiver/transceiver 146 to receive the battery test results transmitted from the communication circuitry 142 and store the battery test results in the memory unit 152.

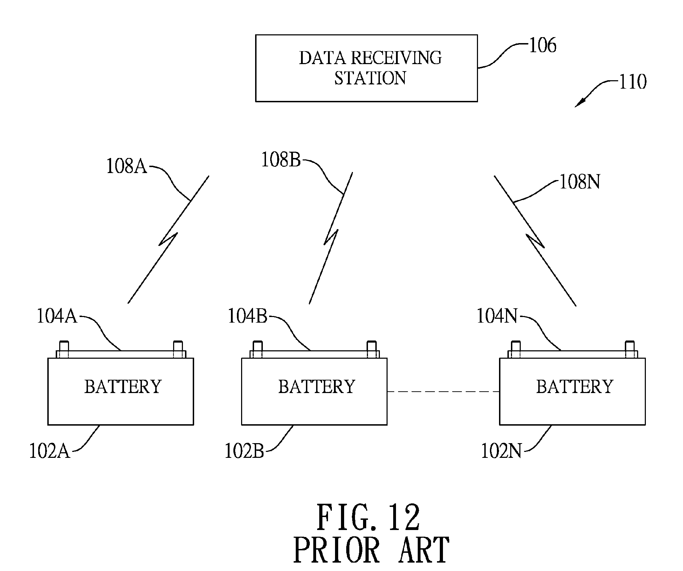

U.S. Patent 7,774,151 discloses a wireless battery monitor. FIG. 12 shows a block diagram of a conventional battery installation. The battery installation 110 includes a plurality of batteries 102A-102N, and each battery 102A-102N is electrically coupled to a respective battery tester 104A-104N. Each battery tester 104A-104N communicates with a data receiving station 106 over a wireless communication medium 108A-108N, respectively. During operation, each battery tester 104A-104N performs a battery test on its respective battery 102A-102N to acquire battery test results. The battery test results are then transmitted along the wireless communication media 108A-108N to the data receiving station 106. According to the battery test results, the data receiving station 106 can act as appropriate by indicating which battery needs replacing, or may need replacing, prior to its ultimate failure.

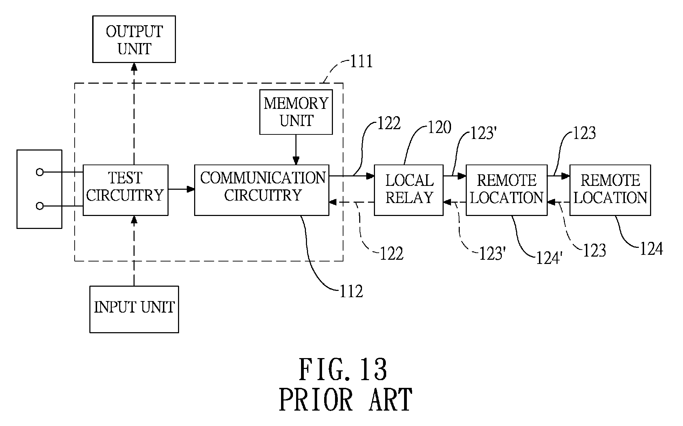

U.S. Patent 8,958,998 discloses an electronic battery tester with network communication. FIG. 13 shows a block diagram of a conventional battery tester. A communication circuitry 112 communicates with a local relay 120 over an optionally bidirectional communication link 122. In particular, the local relay 120 may be a cellular telephone or other cellular based communication device and the local relay 120 can be used to monitor or control operation of the battery tester 111. The local relay 120 communicates with an optional intermediary remote location 124' over an optionally bidirectional communication link 123'. In particular, the intermediary remote location 124' could be a cellular telephone site. The remote location 124' can then communicate with an ultimate destination remote location 124 over another optionally bidirectional communication link 123. The bidirectional communication link 122 with the battery tester 111 can be in accordance with a local communication technology such as a hardwire connection, for example, USB or the like, or a wireless technology such as Bluetooth communication technology, Wi-Fi or others.

However, the above-mentioned U.S. Patents do not disclose an app-based user interface for realization of test and management of a battery tester, thus causing inconvenience of testing and managing the battery tester.

An objective of the present disclosure is to provide a wireless battery management system to introduce an app-based user interface to solve the problem of inconvenience of testing and managing the battery tester.

In order to achieve the above-mentioned objective, the wireless battery management system is configured for managing at least one battery unit. The wireless battery management system includes at least one battery tester and a wireless terminal apparatus. The at least one battery tester is electrically connected to the least one battery unit and configured to test and monitor the at least one battery unit. The wireless terminal apparatus includes a wireless communication unit, a display unit, and a user interface. The wireless communication unit is configured to provide a wireless communication protocol to be wirelessly connected to the at least one battery tester. The user interface is displayed on the display unit and operates an application program of the wireless terminal apparatus, wherein the application program is executed by the wireless terminal apparatus to provide a test and monitor function to control the at least one battery tester to test and monitor the at least one battery unit correspondingly connected to the at least one battery tester.

Accordingly, the friendly and convenient user interface is provided to show states of the battery units under test in detail via an audible manner, lighting, texts, graphics, or animations, thus increasing readability of the battery test results and flexibility and diversification of representing the battery test results, and also increasing convenience of monitoring and sharing the battery test results.

Another objective of the present disclosure is to provide a method of operating a wireless battery management system to introduce an app-based user interface to solve the problem of inconvenience of testing and managing the battery tester.

In order to achieve the above-mentioned objective, the wireless battery management system has at least one battery tester electrically connected to at least one battery unit and a wireless terminal apparatus having a wireless communication unit, a display unit, and a user interface displayed on the display unit and configured to operate an application program of the wireless terminal apparatus, and the application program executed by the wireless terminal apparatus to communicate with the at least one battery tester correspondingly connected to the at least one battery unit. The method includes steps of: characterized in that the method comprising steps of: establishing a connection between the wireless terminal apparatus and the at least one battery tester; controlling the at least one battery tester to execute a test and monitor function by the wireless terminal apparatus; setting a battery testing parameter, a battery monitoring parameter, and battery tester monitoring data on the wireless terminal apparatus; executing the test and monitor function by the wireless terminal apparatus; and outputting testing and monitoring results from the wireless terminal apparatus.

Accordingly, the friendly and convenient user interface is provided to show states of the battery units under test in detail via a sound manner, light manner, text manner, graphic manner or animation manner, thus increasing readability of the battery test results and flexibility and diversification of representing the battery test results, and also increasing convenience of monitoring and sharing the battery test results.

It is to be understood that both the foregoing general description and the following detailed description are exemplary, and are intended to provide further explanation of the present disclosure as claimed. Other advantages and features of the present disclosure will be apparent from the following description, drawings and claims.

### IN THE DRAWINGS

The features of the present disclosure believed to be novel are set forth with particularity in the appended claims. The present disclosure itself, however, may be best understood by reference to the following detailed description of the present disclosure, which describes an exemplary embodiment of the present disclosure, taken in conjunction with the accompanying drawings, in which:
FIG. 1 is a block diagram of a wireless battery management system according to the present disclosure;
FIG.2 is a schematic view of a communication operation between a wireless terminal apparatus and a battery tester according to the present disclosure;
FIG.3 is a schematic view of a user interface displayed on the wireless terminal apparatus according to the present disclosure;
FIG.4 is a block diagram of the battery tester according to the present disclosure;
FIG.5 is a schematic view of a communication network between one wireless terminal apparatus and plural battery testers according to the present disclosure;
FIG.6 is a schematic view of acquirement of external information of the wireless terminal apparatus according to the present disclosure;
FIG.7 is a flowchart of a method of operating the wireless battery management system according to the present disclosure;
FIG.8A is a schematic view showing a first operation page of a user interface according to the present disclosure;
FIG.8B is a schematic view showing a second operation page of the user interface according to the present disclosure;
FIG.8C is a schematic view showing a third operation page of the user interface according to the present disclosure;
FIG.8D is a schematic view showing a fourth operation page of the user interface according to the present disclosure;
FIG.8E is a schematic view showing a fifth operation page of the user interface according to the present disclosure;
FIG.9 is a schematic view of a connection and communication topology between the wireless terminal apparatus and the battery tester according to a first embodiment of the present disclosure;
FIG. 10 is a schematic view of a connection and communication topology between the wireless terminal apparatus and the battery tester according to a second embodiment of the present disclosure;
FIG. 11 is a block diagram of a conventional wireless battery testing system;
FIG. 12 is a block diagram of a conventional battery installation; and
FIG. 13 is a block diagram of a conventional battery tester.

Reference will now be made to the drawing figures to describe the present disclosure in detail.

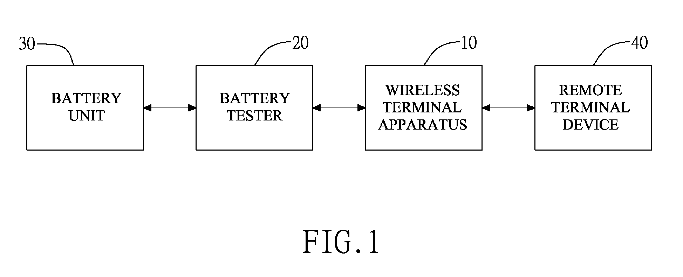

FIG. 1 shows a block diagram of a wireless battery management system according to the present disclosure. The wireless battery management system includes at least one battery unit 30, at least one battery tester 20, a wireless terminal apparatus 10 and a remote terminal device 40. In one example, one battery unit 30 and one corresponding battery tester 20 are exemplified for demonstration in FIG. 1. In the present disclosure, the wireless terminal apparatus 10 is, but not limited to, a personal computer (PC), a notebook computer, a smart phone, or a tablet computer. The remote terminal device 40 is a cloud server, a cloud database, a remote transceiver, or an Email server.

The wireless terminal apparatus 10 provides at least one wireless communication topology, and the at least one wireless communication topology is, but not limited, Wi-Fi, Bluetooth, ZigBee, GSM, GPRS, 3G, or 4G The wireless terminal apparatus 10 is wirelessly connected to the battery tester 20 and the remote terminal device 40 according to the used wireless communication topology. The battery tester 20 is connected to the battery unit 30 by battery clips or o-rings and is used to test the battery unit 30.

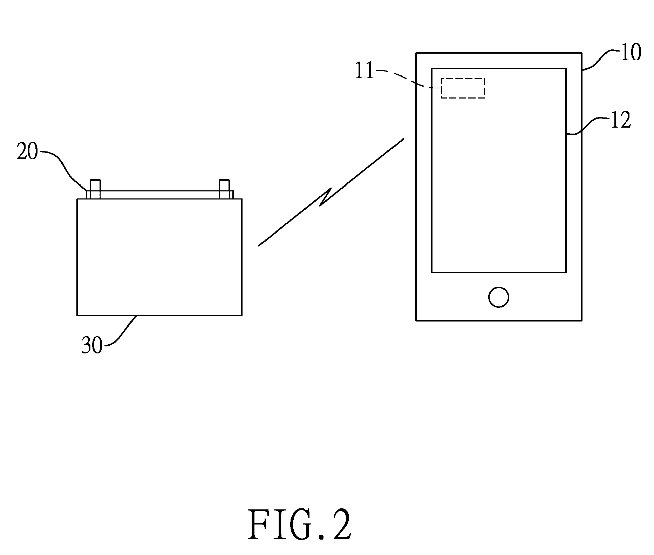

FIG.2 shows a schematic view of a communication operation between a wireless terminal apparatus and a battery tester according to the present disclosure. The wireless terminal apparatus 10 includes a wireless communication unit 11, a display unit 12 and an application program (not shown). The wireless communication unit 11 correspondingly provides one of the above-mentioned wireless communication topologies to make the wireless terminal apparatus 10 connect to the battery tester 20. For example, it is assumed that the wireless terminal apparatus 10 is a smart phone and the wireless communication unit 11 is a Bluetooth communication device providing a Bluetooth communication topology. The smart phone is wirelessly connected to the battery tester 20 according to the Bluetooth communication topology. In addition, the battery tester 20 has the corresponding Bluetooth transceiver in accordance with the wireless terminal apparatus 10. In the present disclosure, the wireless terminal apparatus 10 may have different wireless communication units 11 for providing different wireless communication topologies, thus increasing flexibility and convenience of the wireless connection.

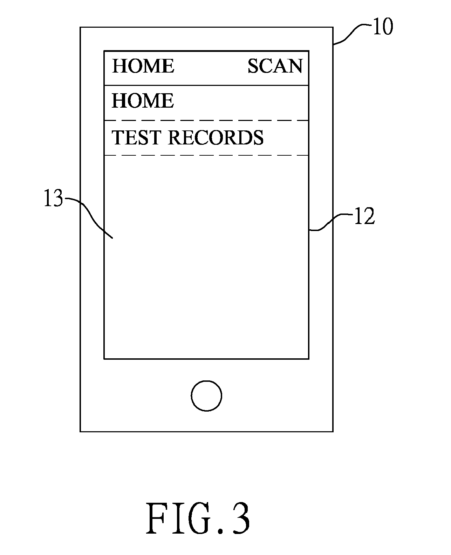

For the smart phone, the application program is a mobile application also called an App. As shown in FIG.3, the mobile application has a user interface 13 and the user interface 13 is displayed on the display unit 12. The user interface 13 is an interface for operating the mobile application, i.e., the user can select operation functions on the user interface 13 of the mobile application to execute the corresponding functions by touching on the user interface 13. An operation of testing the battery unit 30 is exemplified for demonstration, wherein the user executes a battery test function via the mobile application so as to wirelessly control the battery tester 20 testing the battery unit 30 connected to the corresponding battery tester 20. More operation functions are described further hereinafter.

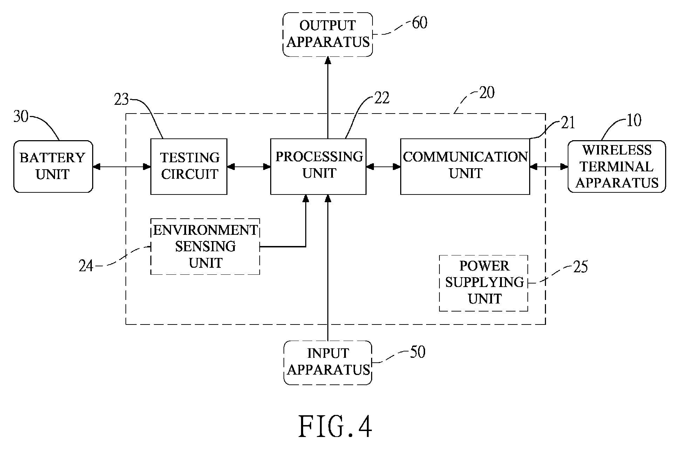

FIG.4 shows a block diagram of the battery tester according to the present disclosure. The battery tester 20 is electrically connected to an input apparatus 50 and an output apparatus 60. The input apparatus 50 may be a physical apparatus or non-physical apparatus with an input function via keys, capacitive/inductive touch, or voice. In addition, the output apparatus 60 may be a physical apparatus or non-physical apparatus with an output function via an audible manner, lighting, texts, graphics, or animations, such as a speaker, indicator light, display, or printer. In the present disclosure, the input apparatus 50 and the output apparatus 60 are optional according to the actual requirement of the user.

The battery tester 20 includes a communication unit 21, a processing unit 22, a testing circuit 23, an environment sensing unit 24 and a power supplying unit 25. In the present disclosure, the environment sensing unit 24 and the power supplying unit 25 are optional according to the actual requirement of the user. The environment sensing unit 24 is used to sense external environmental parameters, such as temperature, humidity, or coordinates. The external environmental parameters sensed by the environment sensing unit 24 are sent to the processing unit 22 and processed or calculated by the processing unit 22.

The battery tester 20 is supplied with power via an external power source. Once the external power source fails, the power supplying unit 25 is used to provide required power to the battery tester 20. When the optional units are all used, the processing unit 22 is connected to the communication unit 21, the testing circuit 23, the environment sensing unit 24, the input apparatus 50 and the output apparatus 60. In the wireless battery management system, the processing unit 22 plays a role of controlling the peripheral units and apparatuses to collect and process data.

A bi-directional or single-directional communication is established between the processing unit 22 and the communication unit 21. In particular, a communication interface, such as UART, I2C, or SPI is used for communication between the processing unit 22 and the communication unit 21. The communication unit 21 transmits data to other units or receives data from other units in a wired manner or a wireless manner.

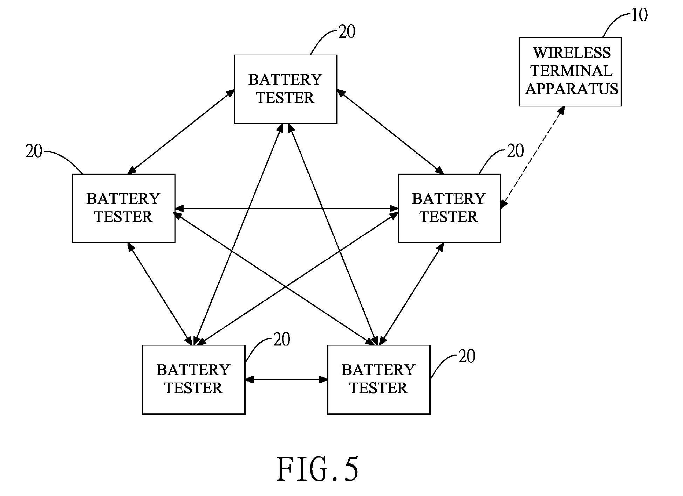

FIG.5 shows a schematic view of a communication network between one wireless terminal apparatus and plural battery testers according to the present disclosure. A mesh topology is formed by the plural battery testers 20, and each battery tester 20 can transmit data to other battery testers 20 and receive data from other battery testers 20 via the wireless communication technology. In addition, each battery tester 20 can be a master role for data transmission or be a slave role for data reception.

In this embodiment, the exchanged data of the battery testers 20 include: check and update of firmware versions, check and update of parameters and test of battery states. For the check and update of firmware versions, each battery tester 20 has the capability of mutually checking and updating firmware version since each battery tester 20 has the wireless communication capability. The battery tester 20 with the latest firmware version could overwrite the latest firmware version for any other battery tester 20 with the older firmware version once an older firmware version of any other battery tester 20 is found, thus accomplishing check and update of firmware version.

For the check and update of the parameters, each battery tester 20 has the capability of mutually checking and updating parameters after the wireless terminal apparatus 10 updates parameters of any one of the battery testers 20. The battery tester 20 with the latest parameters could overwrite the latest parameters for any other battery tester 20 with the older parameters once older parameters of any other battery tester 20 are found, thus accomplishing check and update of parameters.

For the test of battery state, the user interface 13 of the mobile application is operated to control at least one battery tester 20 to test battery states of the corresponding battery unit 30. The wireless terminal apparatus 10 first transmits a battery test command to one of the battery testers 20, and the battery tester 20 first receiving the battery test command is referred to as a starting battery tester. Afterward, the starting battery tester transmits the battery test command to other battery testers 20, and then these battery testers 20 transmit battery test results thereof to the starting battery tester. Finally, the starting battery tester receives the battery test results and transmits the battery test results to the wireless terminal apparatus 10.

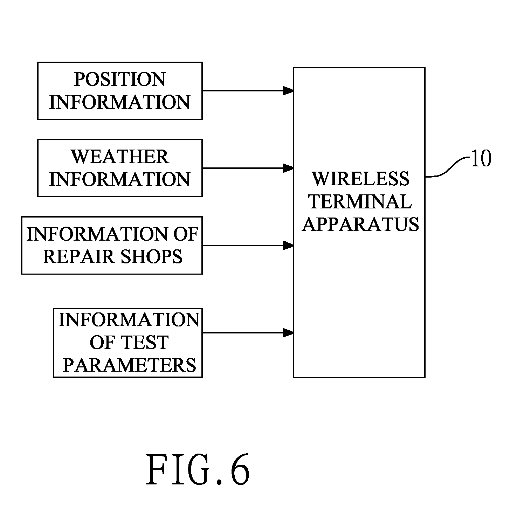

FIG.6 shows a schematic view of acquirement of external information of the wireless terminal apparatus according to the present disclosure. By wired or wireless communication technologies, the wireless terminal apparatus 10 can be externally connected to download and update external information, such as position information, weather information, information of repair shops and/or information of test parameters. For one example, the wireless terminal apparatus 10 can provide the user with the information of the repair shop adjacent to the user, such as business hours, business items, relative distance or so on when the wireless terminal apparatus 10 simultaneously obtains the position information, such as the GPS information and the information of a repair shop. For another example, the wireless terminal apparatus 10 can automatically correct or update test parameters according to the weather information when the wireless terminal apparatus 10 obtains the weather information, such as temperature or humidity.

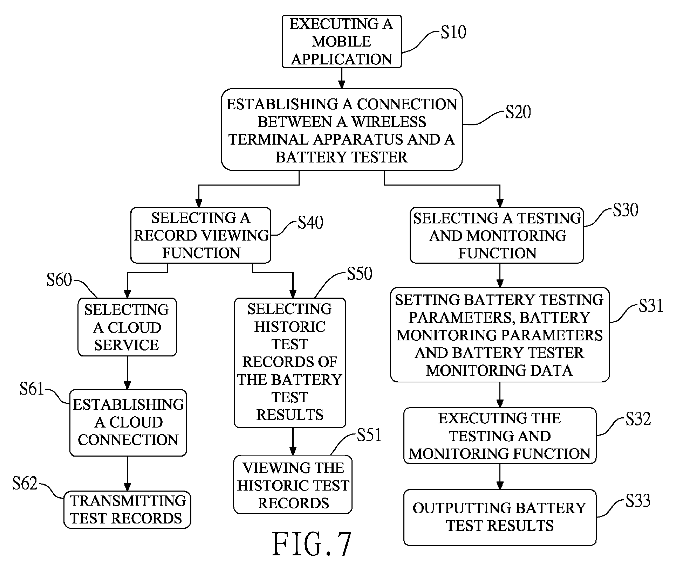

FIG.7 is a flowchart of a method of operating the wireless battery management system according to the present disclosure. The method of operating the wireless battery management system is executed on a wireless terminal apparatus 10, such as a smart phone or a tablet computer. A user interface 13 with a mobile application is operated on a display panel of the smart phone or the tablet computer to execute different functions provided by the wireless battery management system. See more detailed description below.

First, the mobile application is installed in the wireless terminal apparatus 10, and then the wireless battery management system is operated by executing the mobile application (S10). The user can manually execute the mobile application or the wireless terminal apparatus 10 automatically starts to establish a connection between the wireless terminal apparatus 10 and the battery tester 20 (S20). Afterward, a testing and monitoring function is selected (S30) to test and monitor the battery unit 30 or a record viewing function is selected (S40) to view historic records of the battery unit 30 according to the actual requirement of the user.

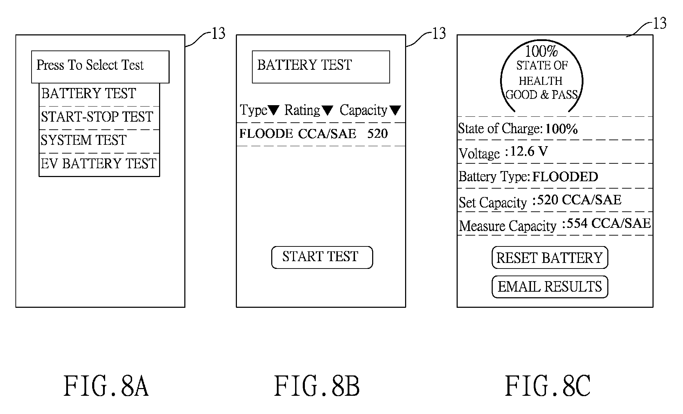

1. The descriptions of the testing and monitoring function. Before being tested and monitored, the battery unit under test has to be connected to the corresponding battery tester 20. After the battery unit under test is connected to the battery tester 20, the user can set battery testing parameters, battery monitoring parameters and battery tester monitoring data via the user interface 13 (S31). The operations of the user interface 13 can be shown in, but not limited by, FIG.8A to FIG.8E.

As shown in FIG.8A, a plurality of items of battery test can be selected through, but not limited to, pull-down menus, of a function page on the user interface 13. When an option "BATTERY TEST" is selected, the battery unit under test is ready to be tested. Further, other options can be selected and the corresponding functions are executed. After the option "BATTERY TEST" is selected, a next option page is shown in FIG.8B. In this option page, the user can select testing conditions, such as battery type, battery rating and battery capacity for the battery unit under test. After the selection is accomplished, the user submits the "START TEST" to control the battery tester 20 starting to test and monitor the battery unit under test (S32). After the battery unit under test is completely tested, test results are immediately displayed on the user interface 13 (S33) as shown in FIG.8C so that the user can realize information including a state of health (SOH) of the battery unit under test. In addition, the test results can be sent in text form to other related personnel via Email.

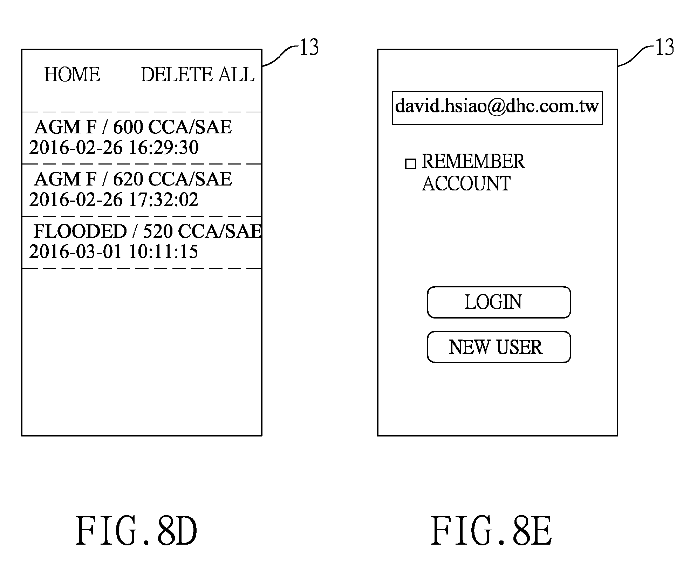

2. The descriptions of the record viewing function. The user can select an option "TEST RECORDS" in the function page on the user interface 13 as shown in FIG.3 and the historic test records of the battery unit under test are listed as shown in FIG.8D (S50). For example, FIG.8D shows a list having a number of historic test records. The user selects any one of the historic test records on the user interface 13 to view the corresponding test result (S51) as shown in FIG.8C. In addition, the historic test records can be sent in text form to other related personnel via Email.

After the step (S40), the user can select a cloud service (S60). The wireless terminal apparatus 10 is wirelessly connected to the remote terminal device 40, such as a cloud server by logging in a cloud account as shown in FIG.8E to establish a cloud connection (S61). In the cloud service, the test records of the battery unit under test can be converted into a document file format, such as *.doc, *.xls, or *.csv, an image file format, such as *.bmp, *.jpg, or *.png, or a video file format, such as *.avi, *.wmv, *.mov, or *.mp4. The converted test records are transmitted (uploaded) to the remote terminal device 40 (S62) and are downloaded or viewed for other related personnel.

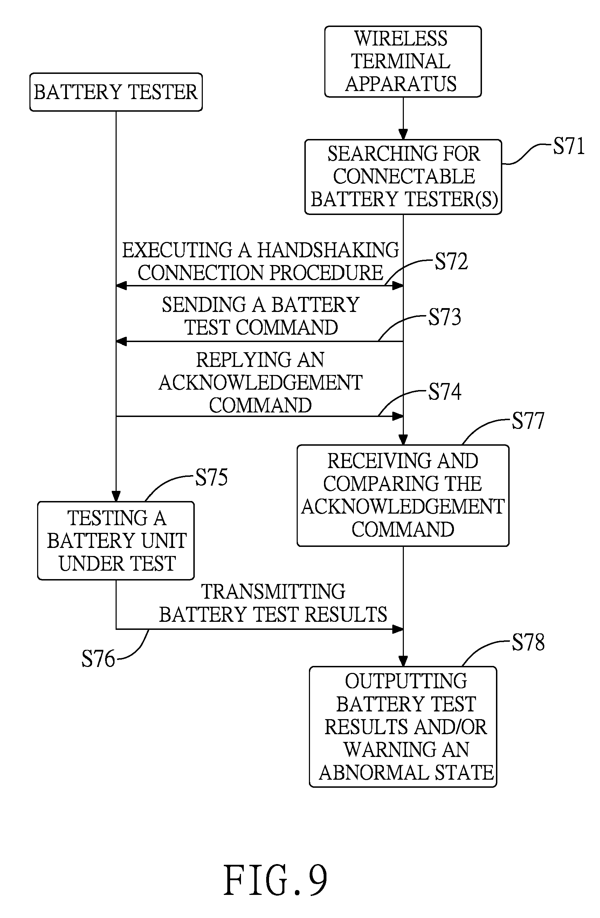

FIG.9 shows a schematic view of a connection and communication topology between the wireless terminal apparatus and the battery tester according to a first embodiment of the present disclosure. In the connection and communication topology, either the wireless terminal apparatus 10 or the battery tester 20 can play a role of a host or a client, i.e., the wireless terminal apparatus 10 is a host when the battery tester 20 is a client and vice versa. In particular, both roles can be interchanged according to the actual requirements, but the wireless terminal apparatus 10 and the battery tester 20 would not play the same role.

In this embodiment, the wireless terminal apparatus 10 is the host and the battery tester 20 is the client for further demonstration as follows. When the communication connection is started up, the wireless terminal apparatus 10 actively searches for peripheral connectable battery tester(s) (S71). In particular, the wireless terminal apparatus 10 selects the eligible battery tester(s) according to device names or reading/writing conditions.

When the eligible connectable battery tester 20 is selected, the wireless terminal apparatus 10 or the battery tester 20 actively or the user manually submits a handshaking connection request to execute a handshaking connection procedure by existing or user-defined communication protocols (S72). In particular, an authentication and an establishment of the handshaking connection request are accomplished after confirming with identifications of characters (or strings) or procedures.

After a handshaking connection of testing battery is accomplished, the wireless terminal apparatus 10 (host) sends a battery testing command to the connected battery tester 20 (S73) so as to notify the battery tester 20 to get ready to test the battery unit under test. In particular, a format and content of the battery testing command is already defined by the wireless terminal apparatus 10 and the battery tester 20.

After the battery tester 20 receives the battery testing command sent from the wireless terminal apparatus 10, the battery tester 20 replies an acknowledgment command with the same content as the battery testing command to the wireless terminal apparatus 10 (S74) so as to notify the wireless terminal apparatus 10 that the battery tester 20 has received an indication of testing the battery unit under test. Afterward, the battery tester 20 tests the battery unit under test (S75) and transmits test results to the wireless terminal apparatus 10 (S76).

After the step (S74), the wireless terminal apparatus 10 receives the acknowledgment command and compares the acknowledgment command with the battery testing command (S77). If the acknowledgment command is not identical to the battery testing command, the wireless terminal apparatus 10 does not receive the test results transmitted from the battery tester 20 and resends the battery testing command to the connected battery tester 20 (S73). On the contrary, if the acknowledgment command is identical to the battery testing command, the wireless terminal apparatus 10 receives the test results transmitted from the battery tester 20 and outputs the test results. Also, the test results are viewed or processed for warning abnormal state of the battery unit under test (S78). The above-mentioned connection manner between the wireless terminal apparatus 10 and the battery tester 20 is referred to as a three-way handshaking protocol, i.e., the connection request, the acknowledgment of the connection request and the acknowledgment of the connection establishment are sequentially performed.

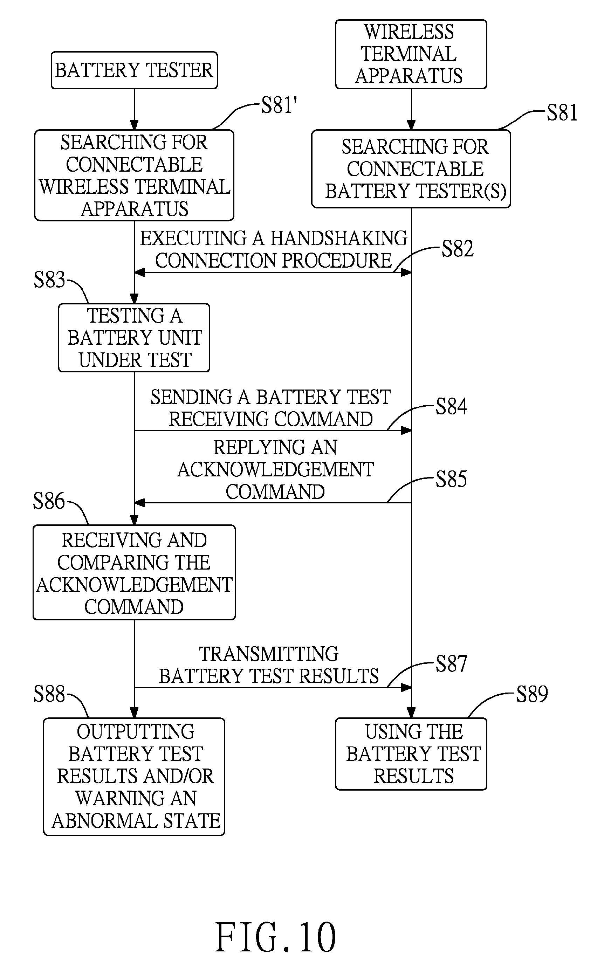

FIG. 10 shows a schematic view of a connection and communication topology between the wireless terminal apparatus and the battery tester according to a second embodiment of the present disclosure. In the connection and communication topology, either the wireless terminal apparatus 10 or the battery tester 20 can play a role of a host or a client, i.e., the wireless terminal apparatus 10 is a host when the battery tester 20 is a client and vice versa. In particular, both roles can be interchanged according to the actual requirements, but the wireless terminal apparatus 10 and the battery tester 20 would not play the same role.

In this embodiment, the battery tester 20 is the host and the wireless terminal apparatus 10 is the client for further demonstration as follows. When the communication connection is started up, both the battery tester 20 and the wireless terminal apparatus 10 can actively search for peripheral connectable wireless terminal apparatus 10 or battery tester(s) (S81),(S81'). In particular, the wireless terminal apparatus 10 selects the eligible wireless terminal apparatus or battery tester(s) according to device names or reading/writing conditions.

When the eligible connectable battery tester 10 or battery tester 20 is selected, the battery tester 20 or the wireless terminal apparatus 10 actively or the user manually submits a handshaking connection request to execute a handshaking connection procedure by existing or user-defined communication protocols (S82). In particular, an authentication and an establishment of the handshaking connection request are accomplished after confirming with identifications of characters (or strings) or procedures.

After a handshaking connection of testing battery is accomplished, the battery tester 20 (host) tests the battery unit under test (S83) and then sends a battery testing receiving command to the connected wireless terminal apparatus 10 (S84) so as to notify the wireless terminal apparatus 10 that the battery tester 20 has tested the battery unit under test. In particular, a format and content of the battery testing receiving command is already defined by the wireless terminal apparatus 10 and the battery tester 20.

After the wireless terminal apparatus 10 receives the battery testing receiving command sent from the battery tester 20, the wireless terminal apparatus 10 replies an acknowledgment command with the same content as the battery testing receiving command to the battery tester 20 (S85) so as to notify the battery tester 20 that the wireless terminal apparatus 10 has been ready to receive test results of the battery unit under test.

After the step (S85), the battery tester 20 receives the acknowledgment command and compares the acknowledgment command with the battery testing receiving command (S86). If the acknowledgment command is not identical to the battery testing receiving command, the battery tester 20 does not transmit the test results to the wireless terminal apparatus 10 and resends the battery testing receiving command to the wireless terminal apparatus 10 (S84). On the contrary, if the acknowledgment command is identical to the battery testing receiving command, the battery tester 20 transmits the test results to the wireless terminal apparatus 10 (S87) and outputs the test results. Also, the test results are viewed or processed for warning abnormal state of the battery unit under test (S88). In addition, the wireless terminal apparatus 10 can analyze, compute, or sort the test results transmitted from the battery tester 20 (S89). The above-mentioned connection manner between the wireless terminal apparatus 10 and the battery tester 20 is referred to as a three-way handshaking protocol, i.e., the connection request, the acknowledgment of the connection request and the acknowledgment of the connection establishment are sequentially performed.

In conclusion, the present disclosure has the following advantages:
1. The user interface 13 of the mobile application is used by the user to operate the wireless terminal apparatus 10 to control and set the battery tester 20 by a wireless communication manner so as to test and monitor the corresponding battery unit 30 connected to the battery tester 20 and also share and backup test results;
2. The friendly and convenient user interface 13 is provided to show states of the battery units under test in detail via an audible manner, lighting, texts, graphics, or animations, thus increasing readability of the battery test results and flexibility and diversification of representing the battery test results, and also increasing convenience of monitoring and sharing the battery test results; and
3. The wireless terminal apparatus 10 provides the display unit 12 for displaying the test results or historic records or operating the operation functions so that no extra liquid crystal display is necessary for the battery tester 20, thus reducing costs of production.

Although the present disclosure has been described with reference to the preferred embodiment thereof, it will be understood that the present disclosure is not limited to the details thereof. Various substitutions and modifications have been suggested in the foregoing description, and others will occur to those of ordinary skill in the art. Therefore, all such substitutions and modifications are intended to be embraced within the scope of the present disclosure as defined in the appended claims.

## Claims

1. A wireless battery management system configured for managing at least one battery unit (30), **characterized in that** the wireless battery management system comprising:
at least one battery tester (20) electrically connected to the at least one battery unit (30) and configured to test and monitor the at least one battery unit (30); and
a wireless terminal apparatus (10) comprising:
a wireless communication unit (11) configured to provide a wireless communication protocol to be wirelessly connected to the at least one battery tester (20);
a display unit (12); and
a user interface (13) displayed on the display unit (12) and configured to operate an application program of the wireless terminal apparatus (10), wherein the application program is executed by the wireless terminal apparatus (10) to provide a test and monitor function to control the at least one battery tester (20) testing and monitoring the at least one battery unit (30) correspondingly connected to the at least one battery tester (20).

2. The wireless battery management system as claimed in claim 1, wherein the application program further provides a record viewing function to view test result records of the at least one battery unit (30).

3. The wireless battery management system as claimed in claim 1, wherein the user interface (13) is configured to provide multiple battery-testing parameter options including a battery type option, a battery rating option, and a battery capacity option.

4. The wireless battery management system as claimed in claim 1, further comprising:
at least one remote terminal device (40) wirelessly connected to the wireless terminal apparatus (10) and configured to provide a cloud service between the wireless terminal apparatus (10) and the at least one remote terminal device (40).

5. The wireless battery management system as claimed in claim 1, wherein a topology of connection between the wireless terminal apparatus (10) and the least one battery tester (20) is a three-way handshaking topology.

6. The wireless battery management system as claimed in claim 1, wherein when the number of the at least one battery tester (20) is plural, the battery testers (20) are mutually connected to form a mesh topology; when a firmware version or a parameter content of any one of the battery testers (20) is updated, said battery tester (20) is configured to update firmware versions or parameter contents of other battery testers (20).

7. The wireless battery management system as claimed in claim 1, wherein the wireless terminal apparatus (10) is a personal computer, a notebook computer, a smart phone, or a tablet computer.

8. A method of operating a wireless battery management system that comprises:
at least one battery tester (20) electrically connected to at least one battery unit (30) and a wireless terminal apparatus (10) having a wireless communication unit (11), a display unit (12), and a user interface (13) displayed on the display unit (12) and configured to operate an application program of the wireless terminal apparatus (10), and the application program executed by the wireless terminal apparatus (10) to communicate with the at least one battery tester (20) correspondingly connected to the at least one battery unit (30);
**characterized in that** the method comprising steps of:
establishing a connection between the wireless terminal apparatus (10) and the at least one battery tester (20);
controlling the at least one battery tester (20) to execute a test and monitor function by the wireless terminal apparatus (10);
setting a battery testing parameter, a battery monitoring parameter, and battery tester monitoring data on the wireless terminal apparatus (10);
executing the test and monitor function by the wireless terminal apparatus (10); and
outputting testing and monitoring results from the wireless terminal apparatus (10).

9. The method as claimed in claim 8, after the step of establishing the connection between the wireless terminal apparatus (10) and the at least one battery tester (20), further comprising steps of:
executing a record viewing function by the wireless terminal apparatus (10);
selecting a testing record and correspondingly producing a view selecting command by the wireless terminal apparatus (10); and
displaying the testing record according to the view selecting command by the wireless terminal apparatus (10).

10. The method as claimed in claim 9, after the step of executing the record viewing function, further comprising steps of:
selecting a cloud service and correspondingly producing a cloud selecting command; and
establishing a cloud connection between the wireless terminal apparatus (10) and at least one remote terminal device (40) and transmitting the testing record according to the cloud selecting command.

11. The method as claimed in claim 8, wherein a topology of connection between the wireless terminal apparatus (10) and the least one battery tester (20) is a three-way handshaking topology.
